Europäisches Patentamt

**European Patent Office**

**Office européen des brevets**

(11) Publication number: **0 653 842 A2**

(12) **EUROPEAN PATENT APPLICATION**

(21) Application number: **95200072.7**

(22) Date of filing: **08.12.89**

(51) Int. Cl.⁶: **H03K 17/62**, H03K 19/173

This application was filed on 13 - 01 - 1995 as a divisional application to the application mentioned under INID code 60.

(30) Priority: **16.12.88 US 285496**
**16.12.88 US 285721**
**16.12.88 US 286310**

(43) Date of publication of application:
**17.05.95 Bulletin 95/20**

(60) Publication number of the earlier application in accordance with Art.76 EPC: **0 373 831**

(84) Designated Contracting States:
**AT BE CH DE ES FR GB GR IT LI LU NL SE**

(71) Applicant: **ADVANCED MICRO DEVICES INC.**
**One AMD Place,**
**P.O. Box 3453**
**Sunnyvale,**
**California 94088-3453 (US)**

(72) Inventor: **Wim, Vincent K. C.**
**1251 Richter Court**
**Milpitas,**
**California 95035 (US)**
Inventor: **Chan, Andrew K.**
**717 Gailden Avenue**
**Palo Alto,**
**California (US)**

(74) Representative: **BROOKES & MARTIN**
**High Holborn House**
**52/54 High Holborn**
**London, WC1V 6SE (GB)**

(54) **Polarity option control logic.**

(57) A logic gate is disclosed which includes a first logic gate circuit for generating an output signal representative of a function of two or more input signals. The present invention provides a NOR gate with a self-latching output, with minimal parts count and power consumption, which is suitable for use in a PAL system.

Polarity option control logic is disclosed which provides an optimized design for a macrocell of a programmable logic array with a minimal parts count.

Finally, an initialization circuit is disclosed which includes a latch circuit for providing a first stable output state immediately after the application of power thereto and a second stable output state at a certain delay on the application of power or when the power reaches a predetermined level.

**EP 0 653 842 A2**

FIG. 6

EP 0 653 842 A2

2

The present invention relates to a polarity option control logic for use with a register which may be used, for example in programmable logic arrays (PLAs) or more specifically, programmable array logic (PAL) circuits.

While the present invention is described herein with reference to illustrative embodiments for particular applications, it should be understood that the invention is not limited thereto. Those having ordinary skill in the art and access to the teachings provided herein will recognize additional modifications, applications, and embodiments within the scope thereof and additional fields in which the present invention would be of significant utility.

## Description of the Related Art

Programmable logic arrays provide "glue logic" for PC (printed circuit) boards. Glue logic is the logic required to interface two boards and generally includes a plurality of AND gates, OR gates and input/output I/O buffers. PLAs consume less space and therefore generally provide glue logic in a less costly manner than individual AND gates, OR gates and I/O buffers.

PLAs also offer the advantage of reconfigurability over discrete or individual gates. That is, PLAs generally include an array of "AND" gates, an array of "OR" gates, and some provision for interconnecting the outputs of selected AND gates to the inputs of selected OR gates PLAs allow a wide variety of logic functions to be implemented through the combination, via the OR gates, of the product terms, provided by the AND gates. Further, the configuration of the array may be quickly, easily and relatively inexpensively reprogrammed to implement other functions.

As described in U.S. Patent No. 4,124,899, programmable array logic circuits were developed to provide further improvements in the speed, space requirements, cost and power consumption of PLAs. In a most general sense, a PAL provides a field programmable logic array in which a programmable array of circuit inputs are provided to a plurality of AND gates to generate product terms. Outputs from subgroups of AND gates are, in turn, nonprogrammably connected as inputs to individual, specified OR gates to provide the sum of products. Hence, PALs provide programmable AND and fixed OR functions relative to generic PLAs.

More specifically, a typical PAL includes a plurality of input and output pads which are essentially connection areas and which facilitate the bonding of a first circuit to another circuit via the "glue logic" provided by the PAL. Each input pad is connected to an input buffer which includes circuitry for detecting address transitions at a corresponding input pad. Each input buffer is connected to the logic array. The logic array provides programmable AND and fixed OR product terms to a set of sense amplifiers. The sense amplifiers detect state changes in the array and provide the array outputs to a plurality of latch blocks. The latch blocks are each connected to a macrocell. The macrocells provide register functions (enable control, D flip-flop, set and reset control and etc.), other output functions, information and state control to an associated output pad.

There is an ongoing effort in the art to reduce the parts count, simplify the design and reduce the power consumption of PALs.

According to the invention, there is provided in a macrocell having a register with first and second input paths, said first input path including an inverter, and first and second switches in each path respectively, polarity option control logic comprising:

first logic means for receiving a clock input and a polarity input signal and controlling the activation of said first switch in response thereto and:

second logic means for receiving said clock input and said polarity input signal inverted and controlling the activation of said second switch in response thereto:

whereby when said polarity input signal is in a first state, said first input path is enabled via said first switch in accordance with said clock signal and when said polarity input signal is in a second state, said second input path is enabled via said second switch in accordance with said clock signal.

Preferably the first logic means includes an AND/OR/INVERT circuit having said clock signal as a first input and said polarity signal as a second input and having an output terminal connected to a control terminal of said first switch.

Preferably said second logic means includes an AND/OR/INVERT circuit having said clock signal as a first input and said inverted polarity signal as a second input and having an output terminal connected to a control terminal of said second switch.

The Polarity Option control logic may also include an inverter having said polarity signal as an input and being connected to said second input of said second AND/OR/INVERT circuit.

**BRIEF DESCRIPTION OF THE DRAWINGS**

Fig. 1 is a simplified block diagram of an illustrative programmable array logic system.

Fig. 2 is a schematic diagram of an illustrative embodiment of the self-latching logic gate of the present invention.

Fig. 3 is an illustrative implementation of a polarity switching circuit of macrocell.

Fig. 4 is an illustrative schematic diagram of a transmission gate.

Fig. 5 is a block diagram of a macrocell constructed in accordance with the teachings of the present invention.

Fig. 6 is a schematic diagram of an illustrative embodiment of a macrocell constructed in accordance with the teachings of the present invention.

Fig. 7 is a schematic diagram of an illustrative embodiment of the initialization circuit of the present invention.

Fig. 8 is illustrative of the output of the initialization circuit of the present invention as a function of time.

**DESCRIPTION OF THE INVENTION**

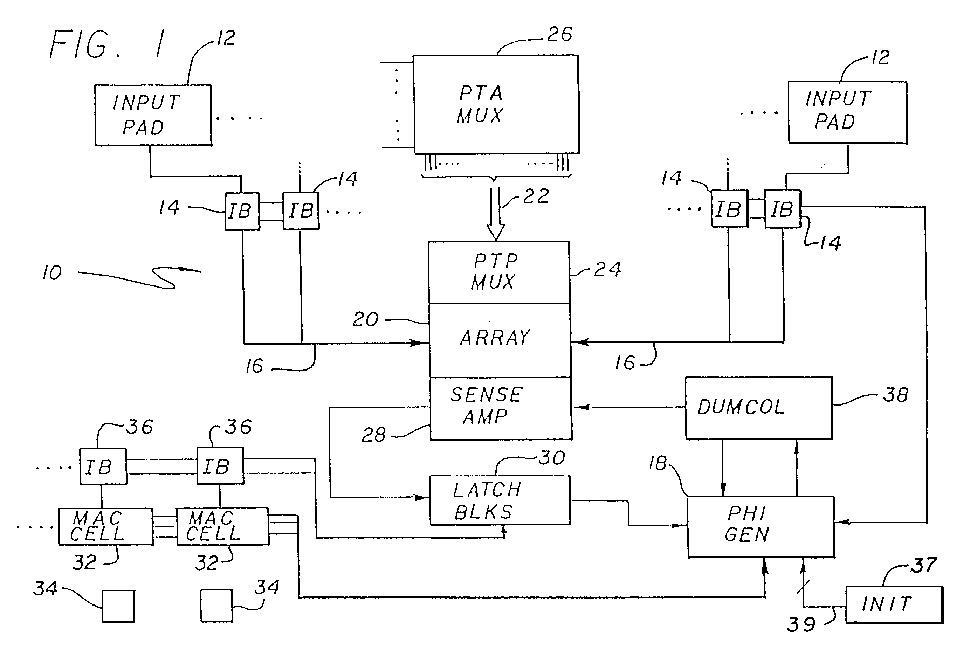

Fig. 1 is a simplified block diagram of an illustrative programmable array logic (PAL) system 10. As is generally known in the art, the PAL 10 is a programmable logic array of a particularly advantageous design providing 'glue logic' for circuit interconnection at high speed with minimal power consumption. The PAL 10 includes a plurality of input pads 12 which are typically probe pads with electrostatic protection circuitry (not shown). The input pads 12 facilitate the bonding of a first circuit to another circuit via the 'glue logic' provided by the PAL 10. Each input pad 12 is connected to an input buffer (IB) 14. Each input buffer 14 includes circuitry for detecting address transitions at a corresponding input pad 12. Each input buffer 14 is connected to a bus 16 and a phi generator 18 called transition detect signal (TDS) bus (not shown). The bus 16 communicates with an array 20. The array 20 typically provides an electrically erasable (E2) cell array of AND gates (not shown). As is known in the art, each input of each AND gate of the array 20 may be programmably interconnected to a selected line of an input data bus 16. A set of sense amplifiers 28 are connected to the array 20. The sense amplifiers 28 are connected to a plurality of latching circuits or latch blocks 30, one for each output of the array 20. As discussed below, the latch blocks include the self-latching logic gate of the present invention. The latch blocks 30 are each connected to a macrocell 32, each of which, in turn, may be connected to one or more of a plurality of output pads 34. The output pads 34 may double as input pads when data is propagated in a reverse direction through the PAL 10 via the input buffers 36. The PLA 10 of Fig. 1 includes an initialization circuit 37 which is connected via a transition detection signal (TDS) bus 39 to the phi generator 18.

In a normal (nonprogramming) mode of operation, the PAL 10 is in a standby mode consuming little or no power. When the input to an input pad 12 is switched, the input data terms propagate through the associated input buffer 14 to the array 20. The address transition detection logic in the input buffer 14 detects the address change at the associated input pad 12 and triggers the phi generator 18. When triggered, the phi generator 18 generates a pulse to the sense amplifiers 28 and the latch blocks 30 and the sense amplifiers 28 and the latch blocks 30 turn on from an initial standby state in which little or no power is consumed. At the same time, the phi generator 18 sends 'BLTCH' and 'LTCH' signals to the latch blocks 30. Input data from a buffer 14 is used by the array 20 to change the states of the product terms. The sense amplifiers 28 detect a state change in the array 20 and drive the latch blocks 30 with product terms therefrom. The 'BLTCH' and 'LTCH' signals from the phi generator 18 enable the latch blocks 30 so that when data is available from the sense amplifiers 28 it is detected and latched by the latch blocks 30 and used to drive the macrocells 32. The macrocells 32 provide register and other output functions (e.g. enable control, D flip-flop, set and reset control and other information and state control) to the associated output pad.

As is known in the art, the timing of the latching function is critical to successful operation of the system 10. If the data is latched early, incorrect data may be output. If the data is latched late, incorrect data may be output or the device may operate at a slower than optimal speed. Accordingly, a dummy column 38 is provided which is essentially a capacitive load. The dummy column 38 is a delay circuit which models the propagation of data through the array 20 to the latch blocks 30. The dummy column 38 therefore provides proper timing for the phi generator 18.

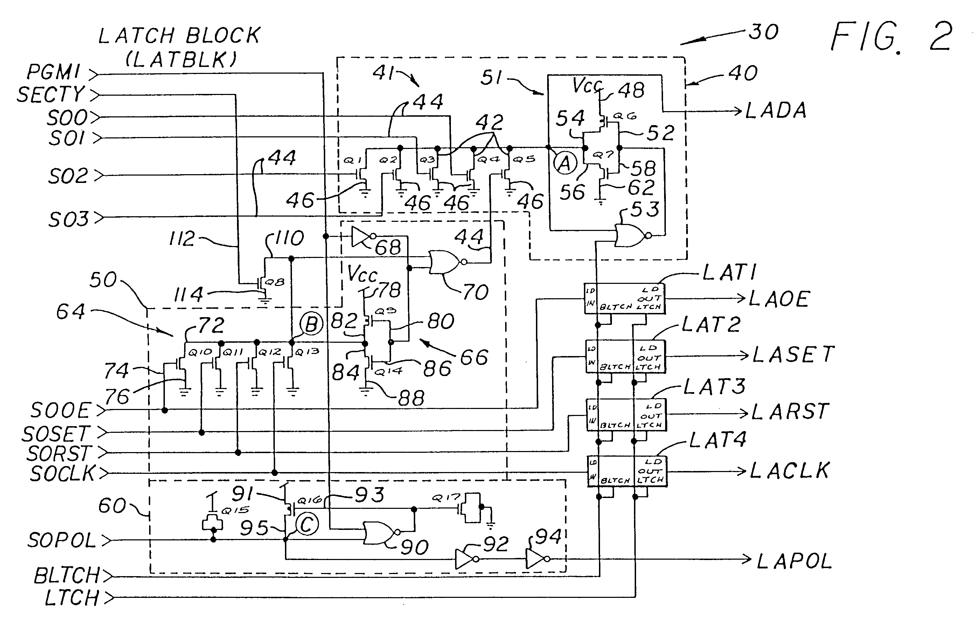

As mentioned above, the latch blocks 30 include latching circuits which, inter alia, provide the logic function (e.g. the OR function) of the product terms and latch the result for output to the associated macrocell 32. Conventional latch blocks have heretofore used a logic gate (e.g. an OR gate) with a separate external latch. As mentioned above, the use of a separate latch adds to the circuit complexity, cost and power consumption and may reduce the speed of the system. One advantageous aspect of the present invention is the provision of a self-latching logic gate which provides the desired logic (OR) function and latches the result for output without the use of a separate latch external thereto. A schematic diagram of an illustrative embodiment of a latch block 30 incorporating the self-latching logic gate of the present invention is shown in Fig. 2. The latch block 30 includes an illustrative implementation of the self-latching logic gate 40 of the present invention, a verification circuit 50, a polarity circuit 60, a plurality of conventional latches LAT1 - LAT4, and a transistor Q8.

The self-latching logic gate 40 includes a plurality of transistors QI - Q5 which provide a first logic gate 41 (NOR gate). Each transistor is implemented as an n-channel MOS device having first, second and third terminals 42, 44, and 46 respectively. The first terminals 42 of each transistor are connected at a common node 'A' to provide an output terminal of the latch block 30 and the logic gate 40. The second terminals 44 of the transistors provide input terminals for the logic gate 40. The first four transistors QI - Q4 receive data input from the sense amplifiers 28 on lines S00 to S03 respectively. The fifth input to the NOR gate 41 is provided to the second terminal 44 of the fifth transistor Q5 by the output of the verification circuit 50. The third terminals 46 of each transistor are connected to a common ground termination.

The self-latching logic gate 40 includes a circuit 51 which provides a latching function. The circuit 51 is comprised of first and second complementary mode transistors Q6 and Q7 and a second logic gate, a NOR gate, 53. The first terminal 48 of the first transistor Q6 of the circuit 51 is connected to a source of electrical potential $V_{cc}$, The second terminal, the input terminal, 52 is connected to the output of the NOR gate 53 and the third terminal 54 is connected to the output terminal of the first NOR gate 41 at node 'A'. Hence, power is supplied to the transistors QI - Q5 from cc through the first transistor Q6 whenever it is activated by a low output from the second logic gate 53. The first terminal 56 of the second transistor Q7 is also connected to the output of the first logic gate 41 at node 'A'. The second (input) terminal 58 of the second transistor Q7 of the circuit 51 is also connected to the output of the second logic gate 53. The third terminal 62 of the second transistor Q7 is connected to ground. The first and second transistors Q6 and Q7 are complementary mode transistors in that the first transistor Q6 is a p-channel transistor and the second transistor Q7 is an n-channel transistor.

The circuit 30 may be fabricated as a chip of silicon or other suitable material on a suitable substrate. Table I below provides illustrative widths and lengths, in microns, of each of the circuit elements for a preferred embodiment of the invention.

TABLE I

| ELEMENT | WIDTH | LENGTH |
|---------|-------|--------|
| Q1 | 25 | 1.8 |
| Q2 | 25 | 1.8 |
| Q3 | 25 | 1.8 |
| Q4 | 25 | 1.8 |
| Q5 | 25 | 1.8 |
| Q6 | 7 | 2 |
| Q7 | 10 | 1.8 |
| Q8 | 10 | 1.8 |
| Q9 | 6 | 15 |
| Q10 | 10 | 1.8 |
| QII | 10 | 1.8 |
| Q12 | 10 | 1.8 |
| Q13 | 10 | 1.8 |
| Q14 | 6 | 1.8 |
| Q15 | 15 | 15 |
| Q16 | 6 | 15 |
| Q17 | 14 | 2/15 |
| INV1 | 6 | 6 |
| INV2 | 6 | 6 |
| INV3 | 10 | 10 |
| NOR1 | 6 | 6 |
| NOR2 | 10 | 6 |
| NOR3 | 6 | 6 |

In operation, when the addresses are not switching at any of the input pads 12, the output of the second NOR gate 53 is high. Thus, Q6 is off and no power is consumed by the self-latching logic gate 40.

When an input is switched at an input pad 12, for example, the associated input buffer 14 triggers the phi generator 18 which, in turn, generates latch signals 'LTCH' and 'BLTCH' for each latch block 30. When the BLTCH signal goes high, the output of the second NOR gate 53 goes low, Q6 turns on and the first NOR gate 41 is enabled.

As mentioned above, the phi generator operates under control of the dummy column 38 to provide proper timing for the generation of the latch signals 'LTCH' and 'BLTCH' relative to the propagation delay of data through the array 20 and sense amplifiers 28. Accordingly, data is received by the first NOR gate 41 at an input 44, at the same time the latch signal BLTCH is received by the second NOR gate 53. Thus, if any of the inputs are high, the output of the self-latching logic gate 40 at node A will be low. If none of the inputs are high, the output of the self-latching logic gate 40 will be high.

In the steady state, the inputs at pad 12 stop switching and the signal BLTCH goes low. As node A provides a second input to the second NOR gate 53, when the output of the logic gate 40 is high, the output of the second NOR gate 53 is low. This keeps Q6 on and node A at a high level. In the steady state, when the output of the logic gate 40 is low, both inputs to the second NOR gate 53 are low and the output of the gate is high. This high state keeps Q6 off, Q7 on and node A tied to ground. The output of the self-latching logic gate 40 will remain low. The outputs of the sense amplifiers 28 are low so no current is f lowing from $V_{cc}$ to ground. This is the generally desired result when the inputs are not switching, i.e., no power consumption and data latched. In any case, the output is provided on line 'LADA' for convenient access by an associated macrocell 32.

The verification circuit 50 of the self-latching logic gate 30 includes a four input logic gate 64, a second set of complementary transistors 66, an inverter 68 and a two input NOR gate 70. The four input NOR gate 64 includes four n-channel transistors Q10 - Q13 arranged in essentially the same configuration as the transistors QI - Q5 of the first logic gate 41. That is, each transistor includes first, second and third terminals 72, 74, and 76 respectively. The first terminals 72 of each transistor are connected at a common node 'B' to provide an output terminal of the gate 64. The second terminals 74 of the transistors provide input terminals for the gate 64. The transistors Q10 - Q13 receive input from the sense amplifiers 28 on lines 'SOOE', 'SOSET', 'SORST' and 'SOCLK' respectively. These signals are also provided to four conventional latches LAT1, LAT2, LAT3, and LAT4. The third terminals 76 of each transistor are connected to ground.

The four input NOR gate 64 is enabled via the complementary mode transistors Q9 and Q14, one of which Q9 is p-channel and the other of which Q14 is n-channel. The p-channel transistor Q9 includes three terminals 78, 80 and 82. The first terminal 78 is connected to a source of electrical potential $V_{cc}$. The second terminal is connected to the output of the inverter 68 and the third terminal is connected to node B. The n-channel transistor Q14 includes first, second and third terminals 84, 86 and 88 respectively. The first terminal 84 is connected to node B, the second terminal 86 is connected to the second terminal 80 of the p-channel transistor Q9, and the third terminal 88 is connected to ground. The two inputs to the two input NOR gate 70 are provided by output of the four input NOR gate 64 and the inverter 68. The output of the two input NOR gate 70 is provided as the fifth input to the self-latching logic gate 40 via the fifth transistor Q5.

When the system 10 is in the programming mode, the sense amplifiers 28 are on and the latches are switched on (into a passthrough mode) as the latches are no longer required. Unfortunately, in the programming mode, the program in the array 20 can not be verified directly because the product terms are used to drive the clock, set, reset and output controls, for example, of the macrocells 32. There is therefore a need for a circuit which would permit the verification of the program stored in the array 20. The verification circuit 50 fills this need by providing an indication as to whether or not the array 20 has been programmed. The four input NOR gate 64 feeds the product terms on lines 'SOOE', 'SOSET', 'SORST' and 'SOCLK' to the first NOR gate 41 via the fifth transistor Q5. Circuit 50 is used to verify 'SOOE', 'SOSET', 'SORSTI and 'SOCLK'. Circuit 40 is also used as verification circuit for S00 to S03.

In operation, in the normal (speed) mode, line 'PGM1' is low and the output of the inverter 68 is high. As a result, the output of the NOR gate 70 is low and the fifth transistor Q5 of the first NOR gate 41 is off. Also, the p-channel transistor Q9 of the verification circuit 50 Q9 is off. The n-channel transistor Q14 is on and it ties down the node B and pulls the NOR gate 64 low.

In the program mode, when the signal on line PGM1 goes high, the output of the inverter 68 goes low and turns off the n-channel transistor Q14 while turning on the p-channel transistor Q9. This enables the four input NOR gate 64. Thus, the fifth transistor Q5 of the first NOR gate 41 Q5 is turned on or off depending on the state of the product terms on lines SOOE, SOSET, SORST and SOCLK via the two input NOR gate 70. That is, if there is a product term programmed at a particular address, the output on line LADA will be high, if not, the output will be low. Each product term is verified individually. For example, if one is verifying SOOE, all other product terms are pulled low by the decoders. This allows for the verification of the cells of the array 20 for particular product terms with minimal additional circuitry.

The polarity circuit 60 includes a p-channel transistor Q16, a NOR gate 90, a buffer provided by two inverters 92 and 94, a pull-up capacitor Q15 and a pull down capacitor Q17. The polarity circuit 60 provides an invert or noninvert control latch for the polarity circuit 100 of the macrocell as discussed below. it allows for the programmability of the polarity of the output of the system 10. The p-channel transistor Q16 includes first, second and third terminals 91, 93 and 95. The first terminal 91 is connected to a source of electrical potential $V_{cc}$, the second terminal 93 is connected to ground via the pull down capacitor Q17, and the third terminal is connected to the polarity input line 'SOPOL'. The inputs to the NOR gate 90 of the polarity circuit 60 are provided by the output of the p-channel transistor Q16 and the program line PGM1. The output of the NOR gate 90 is tied to the input terminal 93 of the p-channel transistor Q16. The output of the polarity circuit 60 appears at node 'C'.

In the normal mode of operation, the program signal on line PGM1 is low and the state of the polarity circuit 60 depends on the polarity of the input on line SOPOL. If the cell in the array 20 providing the polarity signal SOPOL is programmed, the signal SOPOL will be low and the output of the NOR gate 90 will be high. This will turn off the p-channel transistor Q16 and node C will remain low until the polarity signal SOPOL goes high or the system 10 is switched into the program mode (PGM1 goes high). When the polarity signal on line SOPOL is high, the output of the NOR gate 90 will be low, the p-channel transistor Q16 will be on and node C will be held high.

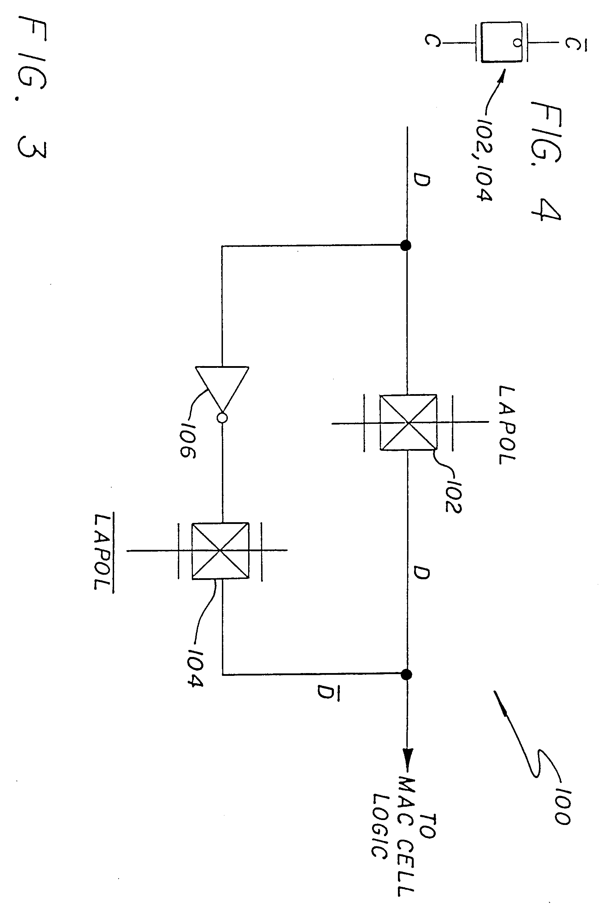

Thus, it will be seen that the polarity circuit 60 acts as a latch. The output from node C is buffered by inverters 92 and 94 before being input to a switching circuit 100 in a macrocell 32 such as that shown in Fig. 3. As shown in Fig. 3, the switching circuit 100 includes two transmission gates or switches 102 and 104 and an inverter 106. (See the illustrative transmission gate of Fig. 4.) An input data term D is fed into the first transmission gate 102 and the inverter 106. The transmission gates are controlled by the LAPOL signal. That is, the LAPOL signal is fed into the clock bar input of the first transmission gate 102 and into the clock input of the second transmission gate 104. Thus, when LAPOL is low, the first transmission gate 102 is on, the output of the switch 100 is D and likewise, when LAPOL is high, the first transmission gate 102 is off, the second gate 104 is on and the output of the switch 100 is the complement of D. The output of the switch 100 is fed to the macrocell logic in a conventional manner.

Returning again to Fig. 2, an n-channel transistor Q8 is shown having a first terminal 110 connected to an input of a NOR gate 70 of the verification circuit 50 and the output of the first NOR gate 64 of the verification circuit at node B. The second terminal 112 of the transistor Q8 is connected to a line 'SECTY' from programming circuitry of the system 10 (not shown). The third terminal 114 is connected to ground.

The transistor Q8 provides a security feature in that when the security cell in the array 20 is programmed, transistor Q8 inhibits the operation of the verification circuit and thereby prevents the verification of the array 20. That is, when the line SECTY is high, Q8 turns on and the input to the NOR gate 70 is low. In the program mode and in the verification mode, the signal on line PGM1 is high. The output of the inverter 68 is low so the NOR gate 70 has two low inputs. Hence the output of the NOR gate 70 is high, Q5 is on and the output of the self-latching gate 40 is high regardless of the status of the product terms. Those skilled in the art will recognize that unauthorized access to the program in the array 20 is effectively prohibited by the arrangement of Fig. 2.

Thus, will be seen by those skilled in the art that the described self-latching logic gate 40 of the present invention provides a latch with minimal additional circuitry and minimum power consumption, without a separate external latch.

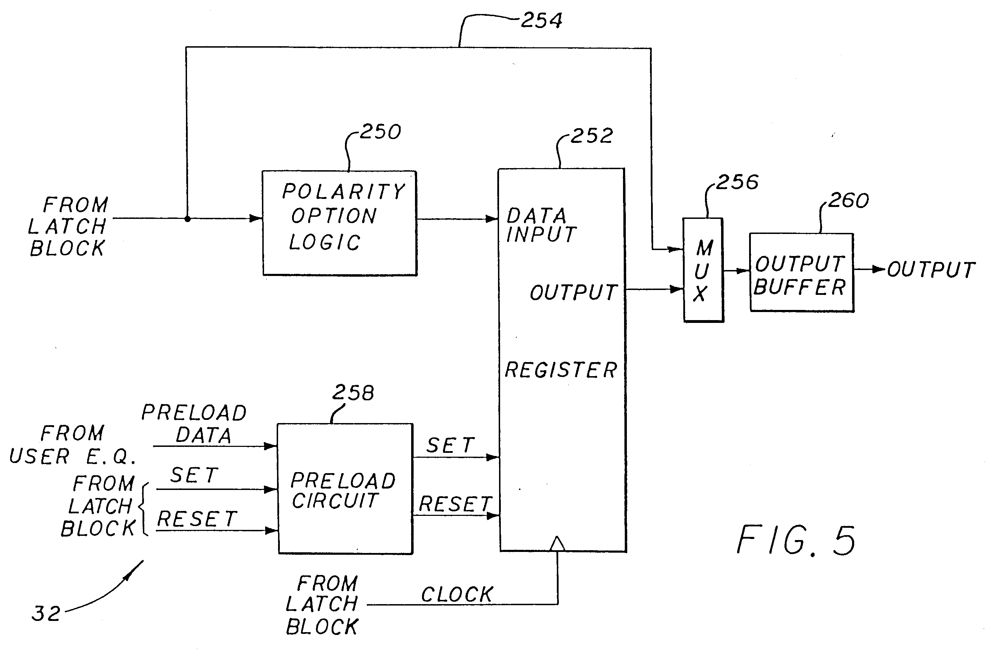

As mentioned above, the described logic gate also provides an optimized design for a macrocell with a minimal parts count. The illustrative embodiment of Fig. 5 shows a simplified block diagram of the macrocell 32, incorporating the present teachings, including polarity option control logic 250 for a register 252, a bypass option provided by a bypass path 254 and a high speed multiplexer 256 and an advantageous preload circuit 258 that minimizes parasitic capacitances at the input to the register 252. The output of the macrocell 32 is provided through a conventional output buffer 36.

Polarity option control logic 250 allows the user to control the polarity of the outputs of the array 20 (the data inputs for the macrocell 32) by programming an appropriate cell of the array 20 to provide the polarity control signal. When a polarity change is programmed, the cell signals the macrocell 32 to change the polarity of the array output. This function is typically provided by a separate polarity option control circuit which splits the nacrocell input into two complementary paths (one including an inverter), each of which includes a switch operable under the control of the polarity cell of the array 20. While this arrangement has been found to be satisfactory for most applications, the present invention provides an alternative which allows for optimized performance with minimal parts count. The polarity option control technique of the present invention includes logic 250 which uses the polarity option signal from the array 20 along with a clock signal to control switches, which are part of the register 252 of the macrocell 32, to provide the polarity option. The approach of the present invention saves space 'real estate' on the PAL chip and may increase the speed of operation of the system.

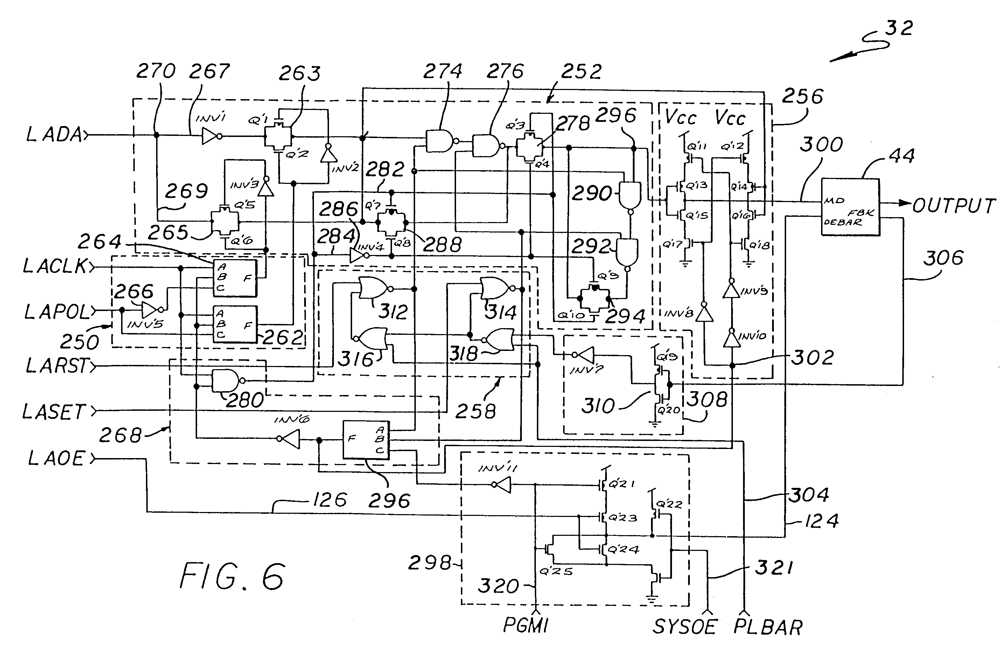

The polarity option control logic 250 of the present invention is presented in the illustrative schematic diagram of a macrocell 32 of Fig. 6. The polarity option control logic circuit 250 of the present invention includes first and second AND/OR/INVERT (AOI) circuits 262 and 264 having clock inputs 'LACLK' as A inputs, bypass inputs as B inputs, and polarity inputs 'LAPOL' as C inputs. The clock and polarity inputs LACLK and LAPOL are provided by the latch blocks 30 while the bypass inputs are provided by a bypass logic circuit 268. The polarity input to the second AOI circuit 264 is inverted by the inverter 266. Thus, the outputs F of the first and second AOI circuits are complementary and related to the inputs by the following relation:

$$F = (AB + C)' \qquad [1]$$

AOI circuits are well known in the art. Further, the invention is not limited to the use of AOI circuits. The function of the AOI circuits may be provided by other logic circuits without departing from the scope of the present invention.

The first and second AOI circuits 262 and 264 are connected to switches 263 and 265, disposed in first and second complementary input paths 267 and 269, respectively, between first and second nodes 270 and 272 in the register circuit 252. The paths are complementary by virtue of the inverter INV'1 in the first path 267. Each switch 263 and 265 includes complementary CMOS transistors Q'1/Q'2 and Q'5/Q'6 respectively. Transistors Q'l and Q'5 are p-channel transistors while transistors Q'2 and Q'6 are n-channel transistors. All transistors are field effect transistors unless otherwise specified. The inputs to the p-channel transistors Q'l and Q'5 are inverted by inverters INV'2 and INV'3, respectively, and the inputs to the inverters INV'2 and INV'3 are tied to the inputs to the n-channel transistors Q'2 and Q'6, respectively, so that both CMOS transistors in a switch are either 'on' together or 'off' together. The sources and drains of each CMOS transistor in each switch are tied together to provide a common source and a common drain and the respective inputs and outputs of each switch. The input of the first switch 263 is connected to the output of the inverter INV'1. The input of the inverter INV'1 is connected to the first node 270 in the register 252. The output of the first switch 263 is connected to the second node 272 in the register 252. The input of the second switch 265 is connected to the first node 270 in the register 252. The output of the second switch 265 is connected to the second node 272 in the register 252. Whenever either switch 263 or 265 is activated by the corresponding AOI circuit 262 or 264, respectively, the corresponding path 267 or 269, respectively, is enabled and data from the corresponding latch block 30 (not shown) is passed thereby to the second node 272 of the register 252. As mentioned above, the outputs F of the first and second AOI circuits are complementary. Thus, the switches 263 and 265 are activated alternately so that only one path 267 or 269 is enabled at a time.

The bypass path 254 is connected between the second node 272 and an input to the high speed multiplexer 256. The second node 272 also provides a first input to a first NAND gate 274 of a first latch of the register 252. The first latch also includes a second NAND gate 276 and a third CMOS switch 278. As discussed more fully below, the second input to the first NAND gate 274 of the first latch is a register reset signal 'LARST' provided from corresponding latch block 30 (not shown) through the preload circuit 258. The output of the first NAND gate 274 is a first input to the second NAND gate 276. As discussed more fully below, the second input to the second NAND gate 276 of the first latch is a register set signal 'LASET' provided from corresponding latch block 30 (not shown) through the preload circuit 258. The output of the second NAND gate 276 is connected to the input to the third switch 278. The third switch 278 operates in a manner similar to that of the first and second switches 263 and 265 under control of a signal from a NAND gate 280 in the bypass logic circuit 268 via the third and fourth paths 284 and 286 and the inverter 286 in the fourth path 286. Whenever the third switch 278 is activated, a fourth CMOS switch 288 is activated which operates in a manner similar to that of the first and second switches 263 and 265 under control of a signal from a NAND gate 280 in the bypass logic circuit 268 via the third and fourth paths 284 and 286 and the inverter 286 in the fourth path 286. The operation of the fourth switch is effective to feed the output of the second NAND gate 276 to the input of the first NAND gate 274 at the second node 272 to complete the first latch.

When the third switch 278 is activated, the output of the first latch is passed on as a first input to a third NAND gate 290 (which is part of a second latch of the register 252) and serves as an output from the register 252 and an input to the high speed multiplexer 256 at a third node 296.

The second latch also includes a fourth NAND gate 292 and a fifth CMOS switch 294. As discussed more fully below, the second input to the third NAND gate 290 of the first latch is a register reset signal 'LARST' provided from corresponding latch block 30 (not shown) through the preload circuit 258. The output of the third NAND gate 290 is a first input to the fourth NAND gate 292. As discussed more fully below, the second input to the fourth NAND gate 292 of the second latch is a register set signal 'LASET' provided from corresponding latch block 30 (not shown) through the preload circuit 258. The output of the fourth NAND gate 292 is connected to the input to the fifth switch 294. The fifth switch 294 operates in a manner similar to that of the first and second switches 263 and 265 under control of a signal from a NAND gate 280 in the bypass logic circuit 268 via the third and fourth paths 284 and 286 and the inverter 286 in the fourth path 286. Note, that the gate of the p-channel transistor Q'9 of the fifth switch 294 is connected to the gate of the n-channel transistor Q'4 of the third switch 278 and the gate of the n-channel transistor Q'10 of the fifth switch 294 is connected to the gate of the p-channel transistor Q'3 of the third switch 278. Thus, whenever the third switch 278 is activated, the fifth switch 294 is deactivated. The operation of the fifth switch 294 is effective to feed the output of the fourth NAND gate 292 296 to complete the second latch.

The high speed multiplexer 256 is a unique and advantageous design including eight transistors Q'll - Q'18 and three inverters INV'8 - INV'10. Transistors Q'll - Q'14 are p-channel transistors while transistors Q'15 - Q'18 are n-channel transistors. Transistors Q'll, Q'12, Q'17 and Q'18 provide power for the multiplexer 256 under the influence of the inverter INV'8 and the buffer provided by the inverters INV'9 and INV'10. Enable control for the multiplexer 256 is provided by an output from an OR/AND/INVERT (OAI) circuit 296 in the bypass logic circuit 268. As discussed more fully below, the OAI circuit 296 receives inputs from the preload circuit 258 and an output enable control circuit 298.

The drains of transistors Q'll and Q'12 of the multiplexer 256 are connected to a source of electrical potential $V_{cc}$, The source of transistor Q'll is connected to the drain of transistor Q'13. The source of transistor Q'12 is connected to the drain of transistor Q'14. The sources of transistors Q'13 and Q'14 and the drains of transistors Q'15 and Q'16 are connected to the output line 300 of the multiplexer 256. The sources of transistors Q'15 and Q'17 are connected to the drains of transistors Q'17 and Q'18 respectively. The sources of transistors Q'17 and Q'18 are connected to a common ground termination. The gates of transistors Q'12 and Q'17 are connected to the output of the inverter INV'8. The gates of transistors Q'll and Q'18 are connected to the output of the inverter INV'9.

One data input to the multiplexer 256 is provided by the complementary arrangement of transistors Q'13 and Q'15. A second data input is provided by the complementary arrangement of transistors Q'14 and Q'16. That is, the gates of the paired transistors Q'13 and Q'15 are connected to the output of the register 252 to provide one input terminal and the gates of the paired transistors Q'14 and Q'16 are connected to the bypass line 254 to provide the second input terminal.

When the signal on the multiplexer enable control line 302 is low, the output of the inverter INV'8 will be high, turning off transistor Q'12 and turning on transistor Q'17, and the output of the inverter INV'9 will be low, turning on transistor Q'll and turning off transistor Q'18. When the signal on the enable control line 302 is high, the output of the inverter INV'8 will be low, turning on transistor Q'12 and turning off transistor Q'17, and the output of inverter INV'9 will be high turning off transistor Q'll and turning on transistor Q'18. Thus, transistors Q'll and Q'17 operate in unison and transistors Q'12 and Q'18 operate in unison and alternately with respect to transistors Q'll and Q'17. Hence, one and only one data input path is enabled at a time. For example, when Q'll and Q'17 are on, Q'12 and Q'18 are off and the output on line 300 will depend on the output of the register 252. If the output of the register 252 is high, transistor Q'15 will be turned on, transistor Q'13 will be off and the output of the multiplexer 256 will be pulled low by transistor Q'15 and Q'17. It is readily seen that if the output of the register 252 is low, transistor Q'13 will be on, transistor Q'15 will be off and the output of the multiplexer 256 will be high. Similarly, when the second data input is enabled, the output of the multiplexer 256 will depend on the signal on the bypass line 254. Thus, the multiplexer 256 switches between the output of the register 252 and the bypass line 254 in response to the signal on the control line 302. The output of the multiplexer 256 is provided to a conventional output buffer 36 and ultimately to an output pad 34.

Those skilled in the art will appreciate the advantageous design of the multiplexer 256.

That is, one advantageous feature of the present multiplexer 256 is the provision of the inputs to the multiplexer 256 via transistor gates, not source and drain terminals as with conventional pass gate and transmission gate type multiplexers.

The preload circuit 258 includes four NOR gates 312, 314, 316, and 318 and serves to preload the register 252 with preload data from the output buffer 34 by manipulating the set and reset signals LASET AND LARST respectively. A preload enable control signal PLBAR is provided as a first input to the fourth NOR gate 318 on line 304. A second input to the fourth NOR gate 318 is provided by line 306 from the output buffer 34 on line 306. This is preload data from memory (not shown) within the output buffer 34. The preload data is buffered by the buffer circuit 308 which includes first and second inverters 310 and INV'7. The first inverter 310 is provided by the CMOS pair of transistors Q'19 and Q'20. When the preload enable signal PLBAR on line 304 is low, the buffered preload data is passed by the fourth NOR gate 318 to the second and third NOR gates 314 and 316 respectively. The third NOR gate 316 receives the preload enable signal on line 304 and preload data from the fourth NOR gate 318. The third NOR gate 316 inverts the preload data and provides the inverted preload data to the first NOR gate 312. The second input to the first NOR gate 312 is the reset signal LARST. The inputs to the second NOR gate 314 are the preload data from the fourth NOR gate 318 and the set signal LASET. As mentioned above, the output of the first NOR gate 312 is input to the first NAND gates 274 and 290 of the first and second latches of the register 252 and is the A input to the OAI circuit 296 of the bypass logic circuit 268. The output of the second NOR gate 314 is input to the second NAND gates 276 and 292 of the first and second latches of the register 252 and is the B input to the OAI circuit 296 of the bypass logic circuit 268. Thus, during preload, the first and second latches of the register 252 are set with preload data by the preload circuit 258. Thereafter, the first and second latches of the register 252 are set by the set and reset signals LASET and LARST from the corresponding latch block 30 of Fig. 1.

Those skilled in the art will appreciate the advantageous design and operation of the preload circuit 258 in that it provides for the preloading of the register 252 without requiring a connection to the input of the register at the data input terminal node 270 as is typical of conventional preload schemes. This minimizes capacitance on the input node 270 and allows for greater speed in operation.

The bypass logic circuit 268 provides for the selective bypassing of the register 252 when the system 10 is in the programming mode during which clock signals are not available for the register 252. The bypass logic circuit includes the OAI circuit 296, an inverter INV'6, and the NAND gate 280. The inputs to the OAI circuit 296 are provided by the outputs of the first and second NOR gates 312 and 314 and the output of the enable control circuit 298. The output enable control circuit 298 receives the normally low programming signal PGM1 on line 320 and the system output enable signal SYSOE on line 322 and an output enable signal LAOE on line 326 from the corresponding latch block 30 of Fig. 1. The output enable control circuit 298 includes six transistors Q'21 - Q'26 and an inverter INV'll. Transistors Q'21 - Q'23 are p-channel transistors and transistors Q'25 - Q'26 are n-channel transistors. The system enable signal SYSOE is received at the gates of transistors Q'22 and Q'26. The drain of Q'22 is connected to $V_{cc}$, The source of Q'22 is connected to the output buffer enable control line OEBAR 324 of the output buffer 34. Thus, whenever, the system output enable signal SYSOE on line 322 goes low, a high is placed on the output buffer enable control line 324 enabling the output buffer 34. When the signal SYSOE on the system enable line 322 goes high, transistors Q'21 - Q'25 are enabled by transistor Q'26. The drain of Q'21 is connected to $V_{cc}$, the gate is connected to the programming line 320, and the source is connected to the drain of Q'23. The gate of Q'23 is connected to the latch enable control line 326 and the source of Q'23 is connected to the output buffer enable control line 324. The gate of Q'24 is also connected to the latch enable control line 326. The drain of Q'24 is connected to the output buffer enable control line 324. The source of Q'24 is connected to the drain of Q'26. The source and drain of transistor Q'25 is connected in parallel with the source and drain of transistor Q'24. The gate of Q'25 and the input of the inverter INV'll are connected the programming line 320.

When the system enable signal SYSOE is high and the programming signal on line 320 is high, a low is placed on the output buffer enable control line 324 by transistors Q'25 and Q'26 disabling the output buffer 34 and a low is provided at the C input of the OAI circuit 296. When the system enable signal SYSOE is high and the programming signal on line 320 is low, the C input to the OAI circuit 296 is high, Q'21 is turned on and output buffer enable is under the control of the LAOE signal on line 326 from the latch block 30 of Fig. 1 through Q'23 and Q'24. That is, if LAOE is low, Q'23 turns on and the output buffer 34 is enabled. If LAOE is high, Q'24 turns on and the output buffer 34 is disabled.

Returning to the bypass logic circuit 268, the C input to the OAI circuit 296 is basically the inverted programming signal PGM1 on line 320. The outp OAI circuit 296 is given by the relation below:

$$F = [(A + B)C]' \qquad [2]$$

OAI circuits are well known in the art. Further, the invention is not limited to the use of OAI circuits. The function of the OAI circuits may be provided by other logic circuits without departing from the scope of the present invention.

Thus, in normal operation, when the programming signal PGM1 is low, the output F of the OAI circuit 296 will depend on the set and reset signals LASET and LARST and the preload data. The output of the OAI circuit 296 is used to control the multiplexer 256 as mentioned above. The output of the OAI circuit 296 is also inverted and input to the NAND gate 280 and the first and second AOI circuits 262 and 264 at the B inputs thereof.

In the programming mode, when the output F of the OAI circuit 296 is high, the multiplexer 256 is in a bypass mode passing the data on the bypass line 254 to the output buffer 34. The output of the NAND gate 280 is high and the clock is disabled from the first and second latches of the register 252. At the same time, the B inputs to the first and second AOI circuits 262 and 264 are low and one of the switches are activated in accordance with the state of the polarity signal LAPOL. This permits the verification of the program stored in the array 20 without interference by the register 252. In the normal mode of operation, the output F of the OAI circuit 296 will depend on the set and reset signals. That is, if F is low, the input to the NAND gate 280 is high and the clock is passed on to the first and second latches of the register 252. At the same time, the B inputs of the AOI circuits 262 and 264 are high and these circuits are enabled for normal operation with the clock and polarity signals LACLK and LAPOL controlling operation of switches 263 and 265.

Thus, the macrocell 32 constructed in accordance with the present teachings can be configured in a register mode with set, reset and preload features or a logic mode with an optimized speed path for both modes of operation.

Finally, as mentioned above, in a normal (nonprogramming) mode of operation, the PAL 10 is in a standby mode consuming little or no power. When power is applied to the system 10, the initialization circuit 37 provides a transition detection signal on the TDS bus 39 which triggers the phi generator 18 to provide a pulse which sets the data latches in the manner discussed more fully below. Thereafter, when the input to an input pad 12 is switched, the input data terms propagate through the associated input buffer 14 to the array 20. The address transition detection logic in the input buffer 14 detects the address change at the associated input pad 12 and triggers the phi generator 18. When triggered, the phi generator 18 generates a pulse to the sense amplifiers 28 (via a dummy column timing circuit 38) and the latch blocks 30. In response, the sense amplifiers 28 and the latch blocks 30 turn on from an initial standby state in which little or no power is consumed. Input data from a buffer 14 which is used by the array 20 to change the states of the product terms which have been electrically programmed to provide input variables. The sense amplifiers 28 detect a state change in the array 20 associated with the generation of product terms and drive the latch blocks 30 with product terms therefrom. Signals from the phi generator 18 enable the latch blocks 30 so that when data is available from the sense amplifiers 28 it is detected and latched by the latch blocks 30 and used to drive the macrocells 32. The macrocells 32 provide register and other output functions (e.g. enable control, D flip-flop, set and reset control, state control and other information) to the associated output pad 34.

Power is consumed only when the inputs switch from one address to another. The power up initialization of conventional PALs is therefore somewhat problematic in that when power is applied to the device, the inputs are not switching. Since, the inputs are not switching, the phi generator will not be triggered and the latches will not be set. Accordingly, even if the inputs are proper for a given set of outputs, those outputs are not generally provided by the latches on power up. There is therefore a need in the art for an initialization circuit for programmable array logic devices and other programmable logic arrays which is addressed by the initialization circuit 37.

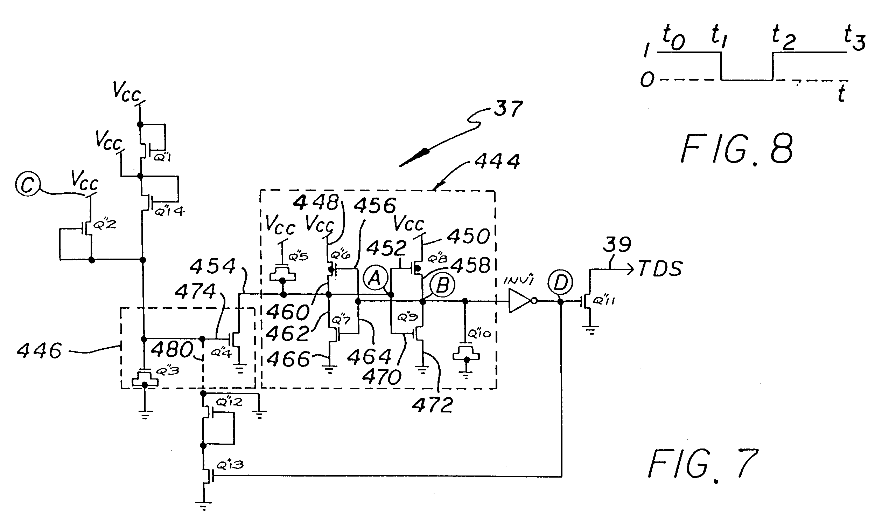

As shown in the illustrative embodiment of Fig. 7, the initialization circuit 37 includes a latching circuit 444 and a first switching circuit 446. The latching circuit 444 includes two sets of CMOS transistors Q''6 and Q''7 and Q''8 and Q''9. Transistors Q''6 and Q''8 are p-channel transistors and transistors Q''7 and Q''9 are n-channel transistors. Each transistor includes first, second and third terminals. The first terminals 448 and 450 of the p-channel transistors Q''6 and Q''8 respectively are connected to a source of electrical potential denoted as $V_{cc}$. The second terminal of the p-channel transistor Q''8 is the input terminal thereof and an input node (node 'A') for the latching circuit 444. The second terminal of the p-channel transistor Q''8 is connected to the first terminal 454 of an n-channel transistor Q''4 of the switching circuit 446 which is the output terminal of the switching circuit 446. The second terminal 456 of p-channel transistor Q''6 is the input terminal thereof and is connected to the third terminal 458 of the p-channel transistor Q''8. The third terminal of the p-channel transistor Q''6 and the first terminal 462 of the n-channel transistor Q''7 are connected to a common node between the second terminal 452 of the p-channel transistor Q''8 and the first terminal 454 of the n-channel transistor Q''4. The second terminal 464 of the n-channel transistor Q''7 is connected to a common node between the third terminal of the p-channel transistor Q''8 and a first terminal 468 of the n-channel transistor Q''9. This node provides an output node (node 'B') for the latching circuit 444. The third terminals 466 and 472 of the n-channel transistors Q''7 and Q''9 are connected to a common ground termination. The second terminal 470 of the n-channel transistor Q''9 is connected to the latching circuit input node at the input terminal 452 of the p-channel transistor Q''8. Those skilled in the art will appreciate that each set of CMOS transistors Q''6 and Q''7 and Q''8 and Q''9 provide an inverter and the interconnection of the two inverters as shown and described above provides a latch. The latch is biased toward a first state on the application of power via $V_{cc}$ by n-channel transistors Q''5 and Q''10. Transistor Q''5 has a gate terminal connected to $V_{cc}$ andsource and drain terminals connected to the input terminal at mode A of the latch 444. In this configuration, the transistor Q''5 provides a pull-up capacitor. Similarly, the gate of the transistor Q''lo is connected to the output terminal of the latch and the source and drain terminals are connected to ground. In this configuration, the transistor Q''10 provides a pull-down capacitor. Other latching arrangements may be used without departing from the scope of the present teachings.

The input terminal 474 of the transistor Q''4 of the switching circuit 446 is connected to the source of electrical potential $V_{cc}$ via a thresholding circuit provided by transistors Q''l and Q''14. Each of these transistors is connected in a diode configuration with the gate and drain terminals connected to $V_{cc}$. The source of Q''l is connected to the drain of Q''14. The drain of the transistor Q''14 is connected to the gate of the transistor Q''4. Thus, the application of $V_{cc}$ to the input of Q''l or the input of Q''14 will determine the number of diode drops and hence the input threshold for the transistor Q''4.

The switching circuit 446 also includes a depletion mode NMOS transistor Q''3, configured as a capacitor, connected between the input terminal of the transistor Q''4 and ground. The gate of transistor Q''3 is connected to the input terminal or gate of transistor Q''4 while the source and drain of the transistor Q''3 are connected to ground. In this configuration, the transistor Q''3 provides a capacitor which stores the initial surge of energy supplied by $V_{cc}$ and provides a delay in the turn on of transistor Q''4.

A transistor Q''2 is connected as a diode between the gate of Q''4 and $V_{cc}$ (at node C) to facilitate the fast recovery thereof. That is, the gate and source of Q''2 is connected to the input terminal of Q''4 while the drain of Q''2 is connected to $V_{cc}$. In this configuration, the transistor Q''2 provides a diode which dissipates energy stored in the capacitor Q''3 when $V_{cc}$ is removed or falls below a predetermined level. As discussed more fully below, transistor Q''2 provides the first of two fast recovery circuits incorporated in the initialization circuit 37 .

An inverter INV''1 is connected to the output node of the latching circuit 444. The inverter INVL feeds the input of an n-channel transistor Q''ll which is output coupled to a transition detection signal bus TDS 39. The source of the transistor Q''ll is connected to ground. The inverter and the transistor Q''ll provide isolation between the initialization circuit 37 and the TDS bus 39.

A second fast recovery circuit is provided by transistors Q''13 and Q''12. Transistor Q''13 is connected in a transistor configuration with the gate thereof connected to the output of the inverter INV''1, the source connected to ground and the drain connected to transistor Q''12. Transistor Q''12 is a depletion NMOS device mode connected in a current source configuration between the transistor Q''13 and ground. A dashed line 480 is shown from the transistor Q''12 to the input of the transistor Q''4 to indicate that as an option, the second fast recovery circuit may be connected to provide for a rapid discharge of the capacitor Q''3.

The circuit 37 may be fabricated as a chip of silicon or other suitable material on a suitable substrate. Table 2 below provides illustrative widths and lengths, in microns, of each of the circuit elements for a preferred embodiment of the invention.

TABLE 2

| ELEMENT | WIDTH | LENGTH |
|---------|-------|--------|
| Q''l    | 6     | 2      |
| Q''2    | 6     | 2      |
| Q''3    | 25    | 25     |
| Q''4    | 10    | 1.8    |
| Q''5    | 25    | 25     |
| Q''6    | 6     | 2      |
| Q''7    | 6     | 10     |
| Q''8    | 6     | 10     |
| Q''9    | 6     | 1.8    |
| Q''10   | 25    | 25     |
| Q''ll   | 15    | 1.8    |
| Q''12   | 6     | 15     |
| Q''13   | 10    | 1.8    |
| INV''1  | 6     | 6      |

Note the skewing in the sizes of the p-channel transistors and n-channel transistors of the latching circuit 444. That is, the ratio of the areas of the transistors Q''9/Q''IO and Q''6/Q''7 is skewed. This skewing in sizes along with the operation of the capacitors Q''5 and Q''10 make the latch 444 power up in a preferred state in the absences of any signals on the input mode.

In operation, at $t_0$ prior to the application of power ($V_{cc}$) to the system 10, Q''10 has a stored charge from the prior cycle so the output of the inverter INVL is low. This keeps Q''ll off to the output of the circuit 37 is high as shown in Fig. 8. At time $t_1$,, on power up,, when power is applied to the system 10, $V_{cc}$ is applied to the initialization circuit 37, current flows through the transistors Q''l and or Q''14, depending on the threshold selected, to the base of the transistor Q''4. However, the capacitor Q''3 delays the turn on of the transistor Q''4. At time $t_1$, $V_{cc}$ is also applied to the base of the transistor Q''8 through the capacitor Q''5. This keeps transistor Q''8 off and turns transistor Q''9 on. At the same time, Q''10 pulls node B down so the latch will be steered into a first state in which the output is low. This will place a low at the input to the inverter INV''1 and a high at the input to the transistor Q''ll. This turns transistor Q''ll on and pulls the TDS bus 39 down as shown at ti in Fig. 8.

At some time $t_2$ after the delay capacitor Q''3 has charged (to a level determined by the ratio of the size of the transistor Q''3 to that of transistor Q''4 and the turn on voltage rating of the transistor Q''4, as is known in the art), the transistor Q''4 of the switching circuit 446 turns on and applies a low to node A, the input of the latching circuit 444. At this time, Q''8 turns on and Q''9 turns off. This places a high on node B causing Q''6 to turn off and Q''7 to turn on. The high at the input to the inverter INV''1 creates a low at the input of the isolation transistor Q''ll which turns it off removing the low from the TDS bus 39.

At some subsequent time $t_3$ when $V_{cc}$ is removed from the system, node C goes to ground, the diode provided by the transistor Q''2 conducts and current flows from the capacitor Q''3 through the diode Q''2 to ground. This effectively discharges the capacitor Q''3 and any voltage stored by the gate-to-source capacitance of the transistor Q''4. Thus, Q''4 turns off. Those skilled in the art will appreciate that the diode Q"2 provides a fast recovery of the circuit 37 on the removal of $V_{cc}$.

Q"12 and Q"13 provide a D.C. path and hence allow a very slow rise time at the $V_{cc}$ node. Those skilled in the art will appreciate that the connection to ground may be broken and the connection to the input of the transistor Q"4 may be provided by the line or strap 480 as part of an easy metal mask modification.

Thus, the fast recovery power up initialization circuit of the present invention has been described with reference to a particular embodiment for a particular application.

While the invention has been described herein with reference to an illustrative embodiment for a particular application, it will be understood that the invention is not limited thereto. Those of ordinary skill in the art will recognize additional modifications, applications and embodiments within the scope thereof. For example, as mentioned above, the invention is not limited to the technique shown for providing a first stable output state immediately after the application of power and a second stable output state after a delay or when $V_{cc}$ reaches a certain level. Further, the invention is not limited to a CMOS, n-channel or p-channel construction. Nor is the invention limited to the fast recovery, thresholding, or isolation schemes disclosed. In addition, the invention is not limited to use in PALs and PLAS. The invention may be used in any circuit or system requiring a low power consumption initialization circuit with fast recovery capability and variable thresholds.

Further, the invention described herein are not limited to implementation in either positive or negative logic. Nor is the invention limited to the use of field effect transistors. Any suitable switching element may be used in place of the transistors in the illustrative embodiments without departing from the scope of the present teachings. Further, the invention is not limited to the NOR gate implementation illustrated herein. For example, an OR gate implementation is clearly anticipated by the present teachings. Nor is the invention limited to the number of inputs on the logic gate. Gates of any size suitable for a particular application may be realized utilizing the principles of the present invention.

Thus, it is intended by the appended claims to cover any and all such applications, modifications and embodiments.

**Claims**

1. In a macrocell (32) having a register (252) with first and second input paths (267,269), said first input path including an inverter (INV1), and first (265) and second (263) switches in each path respectively, polarity option control logic comprising:

   first logic means (264) for receiving a clock input (LACLK) and a polarity input signal (LAPOL) and controlling the activation of said first switch (265) in response thereto and:

   second logic means (262) for receiving said clock input (LACLK) and said polarity input signal (LAPOL) inverted and controlling the activation of said second switch in response thereto:

   whereby when said polarity input signal (LAPOL) is in a first state, said first input path (269) is enabled via said first switch (265) in accordance with said clock signal (LACLK) and when said polarity input signal (LAPOL) is in a second state, said second input path (267) is enabled via said second switch (263) in accordance with said clock signal (LACLK).

2. Polarity option control logic as claimed in claim 1, wherein said first logic means includes an AND/OR/INVERT circuit having said clock signal as a first input and said polarity signal as a second input and having an output terminal connected to a control terminal of said first switch.

3. Polarity option control logic as claimed in claim 1 or 2, wherein said second logic means includes an AND/OR/INVERT circuit having said clock signal as a first input and said inverted polarity signal as a second input and having an output terminal connected to a control terminal of said second switch.

4. Polarity option control logic as claimed in claims 1, 2 or 3, including an inverter having said polarity signal as an input and being connected to said second input of said second AND/OR/INVERT circuit.

FIG. 1

FIG. 2

LATCH BLOCK (LATBLK)

FIG. 3

FIG. 4

102,104

C

C̄

D

LAPOL

102

$\overline{LAPOL}$

106

104

D

D̄

100

TO
MAC CELL
LOGIC

FIG. 5

FIG. 6

FIG. 7

FIG. 8